**Europäisches Patentamt**

**European Patent Office**

**Office européen des brevets**

(19)

(11) Veröffentlichungsnummer: **0 001 588**

**A1**

# (12) EUROPÄISCHE PATENTANMELDUNG

(21) Anmeldenummer: 78101059.0

(22) Anmeldetag: 03.10.78

(51) Int. Cl.²: **G 09 F 9/00**
**G 01 R 13/02**

(30) Priorität: 18.10.77 DE 2746818

(43) Veröffentlichungstag der Anmeldung:
02.05.79 Patentblatt 79/9

(84) Benannte Vertragsstaaten:
CH FR GB NL SE

(71) Anmelder: SIEMENS AKTIENGESELLSCHAFT Berlin
und München
Postfach 261
D-8000 München 22(DE)

(72) Erfinder: Glaubitz, Werner
Vogelhartstrasse 4
D-8000 München 40(DE)

(54) **Anzeigegerät mit einem passiven elektrooptischen Display.**

(57) Die Erfindung betrifft ein Anzeigegerät mit einem passiven elektrooptischen Display. Das Gerät hat ein Gehäuse mit einem Unterteil in Form eines oben offenen Quaders und einer Deckfläche, die das Display in einer gegen die Erstreckungsebene des quaderförmigen Unterteils geneigten Lage trägt. Ein erfindungsgemäßes Anzeigegerät hat folgenden Aufbau: Die Deckfläche (4) ist zumindest in einem das Display (19) enthaltenden Bereich von einer Platte gebildet, die aus einem Material mit einem Brechungsindex größer 1 besteht, fluoreszierende Partikel enthält, dem Display (19) zugeordnete Lichtaustrittsfenster (15) hat und vorzugsweise an ihren Seitenflächen verspiegelt ist ("Fluoreszenzplatte"); das Display (19) wird von einer zur Erstreckungsebene des Displays parallelen Teilfläche (Trägerfläche 14) der Fluoreszenzplatte getragen; für die Übergänge der Trägerfläche (14) zu den übrigen Fluoreszenzplattenbereichen gilt

$$R \geq \frac{d \cdot n_f}{n_f - n_a}$$

(R = äußerer Krümmungsradius, d = Dicke der Fluoreszenzplatte, $n_f$ = Brechungsindex der Fluoreszenzplatte und $n_a$ =

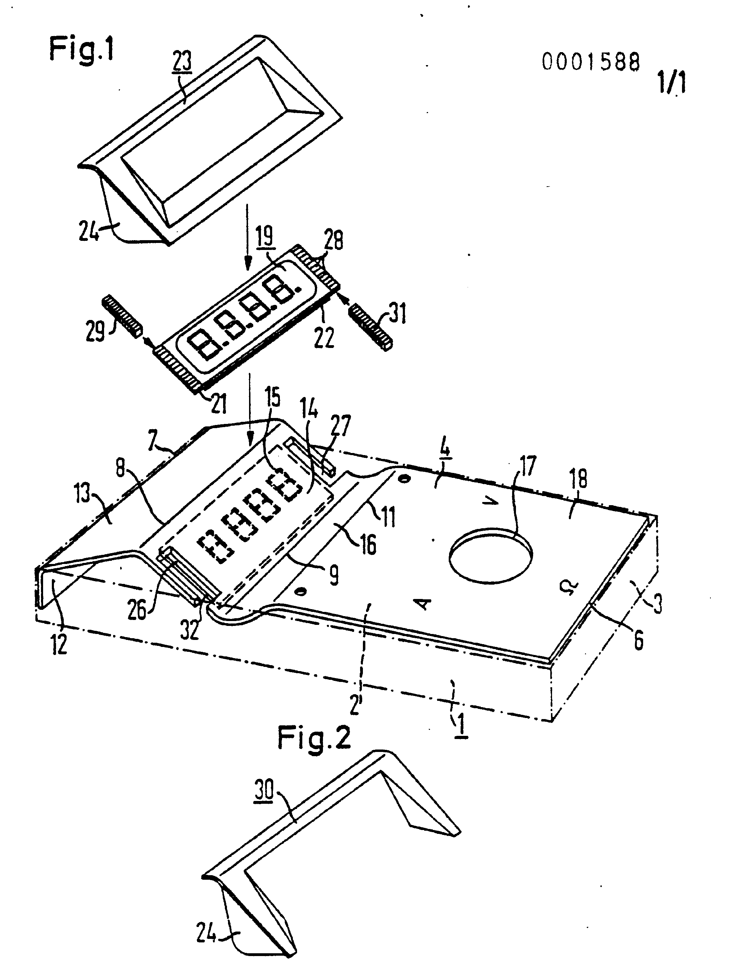

Brechungsindex des Außenraumes; insb. liegen die elektrischen Kontakte (28) des Displays (19) an zumindest einer der beiden Schmalseiten der Display- Anzeigefläche und sind durch eine Ausnehmung (26,27) in der Fluoreszenzplatte in das Gehäuseinnere geführt; und dem Display (19) ist ein mit der Fluoreszenzplatte verbundener Rahmen (23) aufgesetzt (Fig. 1).

./.

EP 0 001 588 A1

Fig.1

SIEMENS AKTIENGESELLSCHAFT      Unser Zeichen
Berlin und München           VPA 77 P 1160 EPC

**<u>Anzeigegerät mit einem passiven elektrooptischen Display</u>**

Die Erfindung betrifft ein Anzeigegerät gemäß dem Oberbegriff des Anspruchs 1. Derartige Instrumente befinden sich bereits auf dem Markt; vergl. hierzu auch "Elektroniker" <u>6</u> (1976) EL 1 bis EL 6.

Bei passiven Anzeigen läßt sich der Darstellungskontrast erheblich steigern, wenn man die eigentliche Anzeigezelle mit einer sog. Fluoreszenzplatte kombiniert. Eine Fluoreszenzplatte besteht aus einem mit fluoreszierenden Partikeln angereicherten Trägermaterial mit einem Brechungsindex größer 1, ist an ihren Seitenflächen verspiegelt und hat spezielle Lichtaustrittsfenster. Ein solcher Körper sammelt einen Großteil des auf ihn treffenden Umgebungslichts durch Fluoreszenzemission und nachfolgende (Total-) Reflexionen an seinen Grenzflächen, leitet die eingefangene Strahlung in seinem Inneren weiter und gibt sie durch seine Lichtaustrittsfenster wieder ab. Setzt man vor die Fluoreszenzplatte ein elektro-optisches Display, dessen Anzeigeelemente mit den Lichtaustrittsfenstern fluchten, so wird die Helligkeit der dargestellten Information um einen Faktor verstärkt, der in erster Näherung dem Verhältnis der lichtsammelnden zur lichtabgebenden Körperfläche entspricht. Nähere Einzelheiten über die geschilderte Anzeigetechnik, für die sich in der·Fachwelt bereits die Bezeichnung FLAD (fluoreszenzaktiviertes Display) eingebürgert hat, sind beispielsweise dem in der "Elektronik-Zeitung" v. 25.3.77 erschienenen Artikel mit dem Titel "Hell und sparsam" oder einem Beitrag in "Elektronik" 6 (1977) 55 zu entnehmen.

Ein FLAD-Gehäuse muß so gestaltet sein, daß die Fluoreszenzplatte eine möglichst große Kollektorfläche hat und das eingefangene Licht mit möglichst geringen Verlusten zu den einzelnen Lichtaustrittsfenstern führt. Dabei hat man darauf zu achten, daß sich die Darstellung auch in einem größeren Raumwinkelbereich noch einwandfrei erkennen läßt und daß nicht zuletzt das gesamte Design auch ästhetisch befriedigend wirkt.

Um die genannten Forderungen zu erfüllen, wird erfindungsgemäß das im Anspruch 1 charakterisierte Anzeigegerät vorgeschlagen.

Bei einer erfindungsgemäßen Gehäuseausführung wird das Umgebungslicht großflächig eingefangen und praktisch ohne Umwege direkt zu den Fenstern fortgeleitet, da sich die vorhandenen Plattendurchbrüche für die elektrische Durchkontaktierung nicht wie sonst an den Breitseiten sondern an den Schmalseiten der rechteckigen Displayanzeigefläche befinden. Verluste an den normalerweise kritischen Knickstellen sind nicht zu befürchten, da die Strahlung aufgrund der geforderten Relation für die Krümmungsradien durch mehrfache Totalreflexion in die neue Richtung umgelenkt werden (vergl. hierzu auch die ältere Patentanmeldung P 27 24 748). Ein weiterer Vorzug ist darin zu sehen, daß der gesamte Gehäusedeckel besonders rationell gefertigt und einfach zusammengesetzt werden kann: Die Fluoreszenzplatte läßt sich in einem Spritzgußprozeß herstellen und kommt unter Umständen sogar ohne jede Verspiegelung aus, das Display kann mit dem - vorzugsweise steckbar ausgeführten und in richtiger Lage einrastenden - Rahmen mit einem Griff (lösbar) fixiert werden und die gesamte Deckeleinheit läßt sich bequem handhaben und rasch mit den übrigen Instrumententeilen vereinigen.

Weitere vorteilhafte Ausgestaltungen und Weiterbildungen der Erfindung sind Gegenstand zusätzlicher Ansprüche.

Die Erfindung soll nun anhand besonders bevorzugter Ausführungsbeispiele unter Bezugnahme auf die beigefügte Zeichnung näher erläutert werden. In den Figuren der Zeichnung sind einander entsprechende Teile mit gleichen Bezugszeichen versehen. Es zeigen:

Fig. 1 ein erstes Ausführungsbeispiel eines erfindungsgemäßen Anzeigegerätes, in einer perspektivischen Explosionsdarstellung, und

Fig. 2 von einem weiteren Ausführungsbeispiel lediglich den Displayrahmen, ebenfalls in einer perspektivischen Ansicht.

Die Figuren sind der Übersicht halber rein schematisch gehalten. Für ein Verständnis der Erfindung nicht unbedingt erforderliche Einzelteile eines Anzeigeinstruments, beispielsweise die im Gehäuseinneren untergebrachten elektrischen Ansteuerbausteine oder die Bedienungselemente, sind unbezeichnet geblieben oder ganz weggelassen.

Das in Fig. 1 dargestellte Instrument dient zur Anzeige von elektrischen Größen; wahlweise kann man die Stromstärke, die Spannungshöhe oder Widerstandswerte messen. Das Gerät hat ein (in der Figur gestrichelt eingezeichnetes) quaderförmiges, oben offenes Unterteil 1 mit einer Bodenfläche 2 und Seitenflächen 3 sowie einen Gehäusedeckel 4. Im vorliegenden Beispiel besteht der gesamte Gehäusedeckel aus einer an ihren Seitenflächen jeweils mit einer Reflexionsschicht 6 versehenen Fluoreszenzplatte. Der Figur entnimmt man, daß die in der Draufsicht rechteckige Fluoreszenzplatte viermal geknickt ist, und zwar jeweils um quer zur Plattenlängsachse verlaufende Achsen 7,8,9 und 11. Diese vier Knickkanten trennen fünf Teilflächen der Fluoreszenzplatte voneinander ab: Eine Randfläche 12, eine Kopffläche 13, eine Lichtaustrittsfenster 15 enthaltende Trägerfläche 14, eine Übergangsfläche 16 und eine mit einer runden Ausnehmung 17 versehene Bedienungsfläche 18. Die Randfläche steht im wesentlichen senkrecht auf der Erstreckungsebene des quaderförmigen Gehäuses, die Bedienungsfläche liegt in dieser Ebene; die übrigen Teilflächen (Flächen 13, 14 und 16) sind gegen die Erstreckungsebene geneigt, und zwar derart, daß die Knickkante 7, an der die Teilflächen 12 und 13 aufeinanderstoßen, etwa auf der Höhe der Bedienungsfläche liegt, während die zwischen den Teilflächen 13 und 14 gelegene Knickkante 8 oberhalb und die Knickkante 9 zwischen der Trägerfläche und der Übergangsfläche unterhalb des Niveaus der Bedienungsfläche liegen. Bei dieser Geometrie hat die Fluoreszenzplatte im Längsschnitt ein Profil mit einer V-förmigen Erhebung und einer V-förmigen Vertiefung. Die Knickkanten 8,9 und 11 sind jeweils abgerundet, wobei für die äußeren Krümmungsradien die Beziehung gilt

$$R \geqslant \frac{d \cdot n_f}{n_f - n_a}$$

(R = äußerer Krümmungsradius, d = Plattendicke, $n_f$ = Brechungsindex der Fluoreszenzplatte und $n_a$ = Brechungsindex des Außenraumes).

Auf der Trägerfläche ruht eine im vorliegenden Fall vierstellige Ziffernanzeige auf Flüssigkristallbasis (Flüssigkristallanzeige 19), und zwar in einer solchen Lage, daß die Lichtaustrittsfenster 15 mit den Anzeigeelementen des Displays fluchten. In der Perspektivansicht der Fig. 1 sind von der Flüssigkristallanzeige lediglich die beiden Trägerplatten (Vorderplatte 21, Rückplatte 22) zu sehen. Eine mehr ins Detail gehende Darstellung des Aufbaus und der Wirkungsweise von Flüssigkristall-Displays ist beispielsweise in "VDI-Z" 115 (1973) 629 zu finden. Gehaltert und abgedeckt wird das Display von einem in der Draufsicht rechteckigen Rahmen 23. Dieser Rahmen enthält an seinen beiden Schmalseiten zwei Zungen, von denen in der Zeichnung nur eine mit 24 bezeichnete Zunge zu sehen ist. Beide Zungen ragen im eingebauten Zustand in Ausnehmungen 26,27 der Trägerfläche 14 hinein. Für den Rahmen braucht man kein fluoreszierendes Material zu nehmen, da das von ihm gegebenenfalls gesammelte Licht nicht ohne weiteres in die Fluoreszenzplatte überführt werden kann und somit dem Display nur zu einem sehr geringen Teil zur Verfügung stehen würde.

Die Vorderplatte 21 der Flüssigkristallanzeige enthält an den beiden Schmalseiten ihrer rechteckigen Grundfläche die für die Displayansteuerung erforderlichen elektrischen Kontakte (Kontakte 28). Hinter diesen beiden Kontaktleisten liegen jeweils sog. Zebra-Kontaktiergummis 29,31, die bekanntlich nur in Richtungen quer zu ihrer Längserstreckung elektrisch leiten. Diese Kontaktelemente ruhen ihrerseits auf einer Schaltungsplatte 32. Bei fertigmontiertem Gerät umgreifen die jeweils mit einem Vorsprung versehenen Rahmenzungen die Schaltungsplatte, so daß die Fluoreszenzplatte, das Display, die Zebra-Kontaktiergummis, die Schaltungsplatte und der Rahmen zusammen eine Baueinheit aus sich gegenseitig halternden Einzelteilen bilden.

In der Bedienungsfläche 18 der Fluoreszenzplatte sind einige der für die Bedienung erforderlichen Zeichen, im Ausführungsbeispiel die Buchstaben "A", "V" und "$\Omega$" als selbstleuchtende Lichtaustrittsfenster eingebracht.

Die drei Buchstaben geben die Stellungen an, in die ein - bei fertigem Gerät durch die Ausnehmung 17 tretender - Schalter zu bringen ist, wenn man den Strom bzw. die Spannung bzw. den Widerstand messen will. Da die Bedienungsfläche mit der Zeit verkratzt werden könnte, empfiehlt es sich, zumindest diese Teilfläche noch mit einer Schutzschicht, etwa einem geeigneten Lackfilm, zu überziehen. Die Schutzschicht sollte vollkommen transparent und optisch an die Fluoreszenzplatte angepaßt sein; ggf. muß man noch eine die Brechungsindizes des Schutzfilms und der Platte ineinander transformierende Anpaßschicht einfügen.

Die lichtsammelnde Fläche der Fluoreszenzplatte ließe sich noch vergrößern, wenn man Teile des Rahmens entfernt. Hierfür bietet sich beispielsweise die in Betrachtungsrichtung gesehen untere Querleiste an. Eine solche, in Fig. 2 dargestellte Rahmenausführung, bringt einen beträchtlichen Helligkeitsgewinn, da Plattenbereiche freigelegt werden, die nahe an den Lichtaustrittsfenstern liegen und das gesammelte Licht auf kürzesten Wegen praktisch ungeschwächt zu den Austrittsfenstern transportieren.

Bei einem nach der Erfindung gebauten Meßgerät hatte die Fluoreszenzplatte folgende Abmessungen: Ihre Länge betrug etwa 153 mm, ihre Breite etwa 100 mm; die Randfläche war ca. 8,5 mm hoch, die Teilflächen 13,14 und 16 waren - projeziert auf die Erstreckungsebene des Gehäuses - ungefähr 22,31,5 und 17 mm lang. Der Neigungswinkel der schrägen Flächen 13,14 und 16 gegen die Erstreckungsebene betrug jeweils 20°, 35° und 45°.

Die abgerundeten Außenkanten 8,9 und 11 hatten jeweils etwa folgende Krümmungsradien: 6,5 mm, 3,5 mm und 6,5 mm. Die Platte hatte eine gleichmäßige Dicke von ca. 1,5 mm.

Die Erfindung beschränkt sich nicht auf die geschilderten und dargestellten Ausführungsbeispiele. Insbesondere bleibt es dem Fachmann überlassen, ob er die Deckfläche vollständig oder nur zum Teil aus einer Fluoreszenzplatte herstellt und welches Profil er der Fluoreszenzplatte gibt, wenn sie nur das Display in geneigter Lage trägt. Im übrigen findet die vorgeschlagene Gehäuseversion bei jeder Art von Meß- und Regelgerät mit Datenanzeige, beispielsweise bei Steuereinheiten zur (Infrarot-)Fernbedienung von Fernsehapparaten oder bei Thermometern mit digitaler Anzeige, Verwendung.

2 Figuren
12 Patentansprüche

Patentansprüche

1. Anzeigegerät, enthaltend ein passives elektrooptisches Display mit rechteckiger Anzeigefläche und ein Gehäuse mit einem Unterteil in Form eines oben offenen Quaders und einer Deckfläche, die das Display in einer gegen die Erstreckungsebene des quaderförmigen Unterteils geneigten Lage trägt, bei welcher die beiden Längsseiten der rechteckigen Display-Anzeigefläche in zur Erstreckungsebene parallelen Ebenen liegen und die beiden Schmalseiten der rechteckigen Display-Anzeigefläche mit der Erstreckungsebene einen Winkel einschließen, d a d u r c h  g e k e n n z e i c h - n e t , daß die Deckfläche (4) zumindest in einem das Display (19) enthaltenden Bereich von einer Platte gebildet ist, die aus einem Material mit einem Brechungsindex größer 1 besteht, fluoreszierende Partikel enthält, dem Display (19) zugeordnete Lichtaustrittsfenster (15) hat und vorzugsweise an ihren Seitenflächen verspiegelt ist ("Fluoreszenzplatte"), daß das Display (19) von einer zur Erstreckungsebene des Displays parallelen Teilfläche (Trägerfläche 14) der Fluoreszenzplatte getragen wird, daß für die Übergänge der Trägerfläche (14) zu den übrigen Fluoreszenzplattenbereichen gilt

$$R \geqslant \frac{d \cdot n_f}{n_f - n_a}$$

(R = äußerer Krümmungsradius, d = Dicke der Fluoreszenzplatte, $n_f$ = Brechungsindex der Fluoreszenzplatte und $n_a$ = Brechungsindex des Außenraumes), daß insb. die elektrischen Kontakte (28) des Displays (19) an zumindest einer der beiden Schmalseiten der Display-Anzeigefläche liegen und durch eine Ausnehmung (26,27) in der Fluoreszenzplatte in das Gehäuseinnere geführt sind und daß dem Display (19) ein mit der Fluoreszenzplatte verbundener Rahmen (23) aufgesetzt ist.

2. Anzeigegerät nach Anspruch 1, mit einem Deckflächenbereich (Bedienungsbereich) in dem sich Bedienungselemente befinden, d a d u r c h   g e k e n n - z e i c h n e t , daß die gesamte Deckfläche (4) bis auf den Bedienungsbereich von der Fluoreszenzplatte gebildet ist.

3. Anzeigegerät nach Anspruch 1, mit einem Deckflächenbereich (Bedienungsbereich), in dem sich Bedienungselemente befinden, d a d u r c h   g e k e n n - z e i c h n e t , daß die gesamte Deckfläche (4) durch die Fluoreszenzplatte gebildet ist und daß die den Bedienungsbereich einnehmende Teilfläche der Fluoreszenzplatte (Bedienungsfläche 18) mit einem transparenten, an die Fluoreszenzplatte optisch angepaßten Schutzlack überzogen ist.

4. Anzeigegerät nach Anspruch 3, d a d u r c h g e k e n n z e i c h n e t , daß zumindest ein Teil der den Bedienungselementen zugeordneten Zeichen, Symbolen oder dergl. als Lichtaustrittsfenster in der Bedienungsfläche (18) der Fluoreszenzplatte ausgebildet sind.

5. Anzeigegerät nach einem der Ansprüche 1 bis 4, d a d u r c h   g e k e n n z e i c h n e t ,daß die Fluoreszenzplatte eine im Profil V-förmige Einsattelung hat, deren eine Fläche als Trägerfläche (14) für das Display (19) dient.

6. Anzeigegerät nach einem der Ansprüche 1 bis 5, d a d u r c h   g e k e n n z e i c h n e t , daß die Fluoreszenzplatte eine im Profil V-förmige Erhebung hat, deren eine Fläche als Trägerfläche (14) für das Display (19) dient.

7. Anzeigegerät nach einem der Ansprüche 1 bis 6, d a d u r c h   g e k e n n z e i c h n e t , daß der Rahmen (23) mit Zungen (24) versehen ist, die durch Ausnehmungen (26,27) in der Fluoreszenzplatte in das Gehäuseinnere hineinragen ("steckbarer Rahmen").

8. Anzeigegerät nach Anspruch 7, d a d u r c h g e k e n n z e i c h n e t , daß sich je eine Zunge (24) an den Schmalseiten des Rahmens (23) befindet.

9. Anzeigegerät nach Anspruch 7 oder 8, d a d u r c h g e k e n n z e i c h n e t , daß den Zungen (24) Vorsprünge angeformt sind, die im Gehäuseinneren einrasten.

10. Anzeigegerät nach einem der Ansprüche 1 bis 9, d a d ur c h   g e k e n n z e i c h n e t ,daß den mit Kontakten (28) versehenen Schmalseiten des Displays (19) jeweils ein Zebra-Kontaktiergummi (29, 31) hinterlegt ist, der durch eine Ausnehmung (26,27) in der Fluoreszenzplatte in das Gehäuseinnere hineinragt und dort eine Schaltungsplatte (32) kontaktiert.

11. Anzeigegerät nach Anspruch 9 und 10, d a d u r c h
g e k e n n z e i c h n e t , daß die Zungenvorsprünge
die Schaltungsplatte (32) umgreifen.

12. Anzeigegerät nach einem der Ansprüche 1 bis 11,
d a d u r c h    g e k e n n z e i c h n e t , daß
bei dem Rahmen (23) eine der beiden Breitseiten, vorzugsweise die in Betrachtungsrichtung gesehen untere
Breitseite, fehlt.

Fig.1

0001588 1/1

Fig.2

**Europäisches Patentamt**

**EUROPÄISCHER RECHERCHENBERICHT**

Nummer der Anmeldung

**EP 78 101 059.0**

| | EINSCHLÄGIGE DOKUMENTE | | KLASSIFIKATION DER ANMELDUNG (Int.Cl.²) |
|---|---|---|---|
| Kategorie | Kennzeichnung des Dokuments mit Angabe, soweit erforderlich, der maßgeblichen Teile | betrifft Anspruch | |
| A | <u>DE - A - 2 554 226</u> (FRAUNHOFER-GES.) <br><br> -- | | G 09 F 9/00 <br><br> G 01 R 13/02 |
| A | <u>DE - A - 2 618 902</u> (VEB) <br><br> -- | | |
| A | <u>DE - U - 7 416 207</u> (SOLARTRON) <br><br> ---- | | |

**RECHERCHIERTE SACHGEBIETE (Int. Cl.²)**

G 01 R 13/02

G 09 F 9/00

G 09 F 9/30

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

X | Der vorliegende Recherchenbericht wurde für alle Ansprüche erstellt.

| Recherchenort | Abschlußdatum der Recherche | Prüfer |
|---|---|---|
| **Berlin** | **14-12-1978** | **FUCHS** |